# EUROPÄISCHE PATENTSCHRIFT

(11) **EP 2 596 642 B1**
(45) Veröffentlichungstag und Bekanntmachung des Hinweises auf die Patenterteilung: **25.10.2017**
(21) Anmeldenummer: 11732490.5
(22) Anmeldetag: 18.07.2011
(51) Int. Cl.: H04N 13/02, H04N 5/225, H04N 5/335, H04N 5/357, G06T 5/00, H01L 27/146

(54) **BILDAUFNAHMEVORRICHTUNG UND VERFAHREN ZUM AUFNEHMEN EINES BILDES**
APPARATUS AND METHOD FOR IMAGE RECORDING
APPAREIL ET PROCÉDÉ POUR ENREGISTRER DES IMAGES

(30) Priorität: 29.04.2011 US 201113098208; 19.07.2010 DE 102010031535
(43) Veröffentlichungstag der Anmeldung: 29.05.2013
(73) Patentinhaber: Fraunhofer-Gesellschaft zur Förderung der angewandten Forschung e.V., 80686 München (DE)
(72) Erfinder: OBERDÖRSTER, Alexander, 07749 Jena (DE); BRÜCKNER, Andreas, 00743 Jena (DE); WIPPERMANN, Frank, 98617 Meiningen (DE)
(74) Vertreter: Schenk, Markus
(86) Internationale Anmeldenummer: PCT/EP2011/062266
(87) Internationale Veröffentlichungsnummer: WO 2012/019875

(56) Entgegenhaltungen:
- EP-A1- 1 912 434
- EP-A2- 0 840 502
- JP-A- 6 292 050
- US-A1- 2009 245 696
- KITAMURA Y ET AL: "Reconstruction of a high-resolution image on a compound-eye image-capturing system", APPLIED OPTICS, OPTICAL SOCIETY OF AMERICA, WASHINGTON, DC; US, Bd. 43, Nr. 8, 10. März 2004 (2004-03-10), Seiten 1719-1727, XP002628317, ISSN: 0003-6935, DOI: 10.1364/AO.43.001719
- FOOTE J ET AL: "FlyCam: practical panoramic video and automatic camera control", MULTIMEDIA AND EXPO, 2000. ICME 2000. 2000 IEEE INTERNATIONAL CONFEREN CE ON NEW YORK, NY, USA 30 JULY-2 AUG. 2000, PISCATAWAY, NJ, USA,IEEE, US, Bd. 3, 30. Juli 2000 (2000-07-30), Seiten 1419-1422, XP010512772, DOI: 10.1109/ICME.2000.871033 ISBN: 978-0-7803-6536-0
- EUNCHEOL CHOI ET AL: "Super-resolution approach to overcome physical limitations of imaging sensors: an overview", INTERNATIONAL JOURNAL OF IMAGING SYSTEMS AND TECHNOLOGY, WILEY AND SONS, NEW YORK, US, Bd. 14, Nr. 2, 1. Januar 2004 (2004-01-01) , Seiten 36-46, XP002504039, ISSN: 0899-9457, DOI: 10.1002/IMA.20006
- VAISH V ET AL: "Using plane + parallax for calibrating dense camera arrays", PROCEEDINGS OF THE 2004 IEEE COMPUTER SOCIETY CONFERENCE ON COMPUTER VISION AND PATTERN RECOGNITION 27 JUNE-2 JULY 2004 WASHINGTON, DC, USA, PROCEEDINGS OF THE 2004 IEEE COMPUTER SOCIETY CONFERENCE ON COMPUTER VISION AND PATTERN RECOGNITION IEEE COMP, Bd. 1, 27. Juni 2004 (2004-06-27), Seiten 2-9, XP010708981, DOI: 10.1109/CVPR.2004.1315006 ISBN: 978-0-7695-2158-9
- MIN LI ET AL: "Reconstruction of Bionic Compound Eye Images Based on Superresolution Algorithm", INTEGRATION TECHNOLOGY, 2007. ICIT '07. IEEE INTERNATIONAL CONFER ENCE ON, IEEE, PI, 1. März 2007 (2007-03-01), Seiten 706-710, XP031127194, ISBN: 978-1-4244-1091-0

## Beschreibung

Die vorliegende Erfindung bezieht sich auf eine Bildaufnahmevorrichtung und ein Verfahren zum Aufnehmen eines Bildes.

Die Miniaturisierung von Kameramodulen und die Reduktion ihrer Herstellungskosten stellt in vielen Bereichen, wie z.B. dem Bereich der Mobiltelefonkameras und dem Bereich der Fahrzeugtechnik, ein wichtiges Ziel dar. Die Modulgröße steht im Verhältnis zur Pixelgröße in allen Dimensionen. Das gilt auch für die Länge entlang der optischen Achse: kleinere Pixel reduzieren die Sensorgröße bei einer gegebenen Gesamtanzahl der Pixel; ein kleinerer Sensor ermöglicht eine kürzere Brennweite bei gegebenem Blickfeld. Die minimale Ausdehnung entlang der optischen Achse eines Kameramoduls wird hauptsächlich durch die Brennweite des optischen Systems begrenzt.

Multikanalabbildungssysteme versprechen - inspiriert durch die Facettenaugen von Insekten - Fortschritte in beider Hinsicht, nämlich Miniaturisierung und Kostenreduzierung. Anstelle eines einzigen Linsenstapels mit einer Ausdehnung in der Größenordnung einiger Millimeter besteht das optische System bei Mehrkanalabbildungssystemen aus einem Array von Mikrolinsen. Die Mikrobilder, die durch diese Mikrolinsenarrays erzeugt werden, werden optisch oder elektronisch zu einem einzigen Bild kombiniert. Bei einem bestimmten vorgegebenen Blickfeld des Gesamtsystems beträgt die Brennweite der Mikrolinsen eines solchen Mehrkanalabbildungssystems lediglich ein Bruchteil der Brennweite eines Einzelkanalsystems, wodurch die Aufbauhöhe entlang der optischen Achse reduziert und die Schärfentiefe signifikant erhöht wird. Da jedes Mikrobild lediglich einen kleinen Ausschnitt des Blickfeldes abdeckt, können die optischen Systeme einfach gestaltet werden: eine Linse und wenige Aperturen pro Kanal sind häufig ausreichend. Da die Mikrolinsen einen Durchmesser von der Größenordnung von Hunderten von Mikrometern und eine Scheitelhöhe im Bereich von mehreren 10 Mikrometern aufweisen, können sie kosteneffektiv im Waferverbund und mit hoher Präzision hergestellt werden.

Bisher war es allerdings eine Herausforderung, eine ausreichende Auflösung für Anwendungen zu erzielen, wie z.B. bei Kameras, Handys oder dergleichen. Trotz des relativ achsparallelen Strahlengangs jedes Einzelkanals treten pro Kanal optische Verzeichnungen auf, was das Aneinanderfügen der einzelnen Teilbilder auf den einzelnen Abbildungskanälen erschwert. Wird der Versuch unternommen, Mikrolinsenarrays und zugehörige Teilbereiche des Bildsensors derart exakt zueinander auszurichten, dass die Einzelbildarrays aus den Teilbereichen des Bildsensors lediglich noch zu einem Gesamtpixelarray zusammengefügt werden müssen, so bedeutete dies hohe Anforderungen an die Herstellungstoleranzen und an die Toleranzen beim Zusammenbau von Bildsensor und Mikrolinsenarray. In Brückner, Duparre, Dannberg, Leitel und Bräuer: "Driving Microoptical Image System towards Miniature Camera Applications, Micro-Optic 2010, Proceedings of SPIE, Bd. 7716, wird ein Algorithmus zur Kombination von Teilbildern eines Mehrkanalabbildungssystems zu einem Gesamtbild beschrieben, der mehrstufig abläuft: Die Mikrobilder werden zunächst invertiert und dann entzerrt, woraufhin die Mikrobilder unter Berücksichtigung der Parallaxe durch Umsortierung zu einem Gesamtbild zusammengefügt werden. Die Entzerrung wird dabei mit Subpixelgenauigkeit durchgeführt. Die so erhaltenen einzelnen Bildpunktwolken werden einer Interpolation unterzogen, um jeweils entzerrte Teilbilder zu erzeugen, bei denen die Bildinformationen auf ganzzahlige Pixelpositionen festgelegt sind. Diese Teilbilder werden schließlich durch Umordnung der Pixel bzw. Ineinanderanordnen der Pixel in den Überlappbereichen der entzerrten Teilbilder zu einem Gesamtbild verflochten. Obwohl die dort offenbarte Vorgehensweise das obige Problem der hohen Anforderung an die Herstellungsgenauigkeiten reduziert, bleibt ein Problem, dass aufgrund von Fehlanpassungen der individuellen Bearbeitung der Teilbilder Artefakte in dem erzeugten Gesamtbild entstehen können, insbesondere entlang der Überlappbereiche der Teilbilder. Probleme ähnlicher Art, wie sie im Vorhergehenden Bezug nehmend auf die Mehrkanalabbildungssysteme zur Erzielung eines größeren Gesamtgesichtsfeldes beschrieben worden sind, treten auch bei anderen Anwendungen auf. Die US 2010/013857 A1 mit dem Titel "Scene independent Method for Image Formation in lenslet Array Images" beschreibt beispielsweise ein Array von Mikrolinsen, bei dem die Linsen in etwa in die gleiche Richtung schauen und den gleichen Bildöffnungswinkel haben. Die Blickrichtungen der einzelnen Mikrolinsen unterscheiden sich allerdings minimal. Insbesondere wird in dem Patent beschrieben, wie die Blickrichtungsunterschiede der einzelnen Teilbilder ermittelt werden können. Dazu wird unter anderem beschrieben, wie die Teilbilder sehr genau aufeinandergelegt werden können, wobei dort eine globale Verschiebung verwendet wird. Eine eventuelle Verzeichnung der Einzelbilder wird allerdings nicht kompensiert.

Die objektive Aufgabe der vorliegenden Erfindung besteht darin, eine Bildaufnahmevorrichtung und ein Verfahren zum Aufnehmen eines Bildes zu schaffen, so dass mit relativ wenig Aufwand in Bezug auf Herstellung und an Hardware eine ansprechende Qualität eines Gesamtbildes erhalten werden kann, wenn zur Aufnahme eine Mehrkanaloptik verwendet wird.

Diese Aufgabe wird durch eine Bildaufnahmevorrichtung gemäß Anspruch 1 und ein Verfahren gemäß Anspruch 15 gelöst.

Gemäß einem Ausführungsbeispiel der vorliegenden Erfindung umfasst eine Bildaufnahmevorrichtung einen Bildsensor mit einer Vielzahl von Bildpunkten, der ausgebildet ist, um in einer Aufnahme einen Abtastwert pro Bildpunkt zu erfassen sowie eine Optik zur Erzeugung einer optischen Abbildung auf dem Bildsensor, wobei die Optik eine Mehrkanaloptik zum individuellen Bilden sich überlappender Raumwinkelbereiche auf separate Teilbereiche des Bildsensors umfasst. Jedem Bildpunkt des Bildsensors ist ein Abbildungswert zugeordnet, und die Abbildungswerte sind Abbildungsrichtungen, von der aus die Optik Objekte auf den jeweiligen Bildpunkt abbildet, oder laterale Abbildungspositionen in einer Schärfentiefenfläche, die die Optik auf den jeweiligen Bildpunkt abbildet. Schließlich umfasst die Bildaufnahmevorrichtung einen Interpolator zum Interpolieren einer Verteilung der Abtastwerte der Bildpunkte gemäß ihren Abbildungswerten an Kreuzungspunkten eines regelmäßigen, sich über die gesamte Verteilung der Abtastwerte erstreckenden Gitters, um ein Array von Bildwerten zu erhalten.

Eine Erkenntnis der vorliegenden Erfindung besteht darin, erkannt zu haben, dass ein verbessertes Verhältnis zwischen Hardware-/Herstellungsaufwand auf der einen und Bildqualität auf der anderen Seite unter Verwendung einer Mehrkanaloptik erzielt werden kann, wenn die Abtastwerte der Bildpunkte gemäß einer Abbildungsrichtung, von der aus die Optik Objekte auf dem jeweiligen Bildpunkt abbildet, oder einer lateralen Abbildungsposition in einer Schärfentiefenfläche, die die Optik auf den jeweiligen Bildpunkt abbildet, angeordnet und die so angeordnete Verteilung von Abtastwerten der Bildpunkte an Kreuzungspunkten eines regelmäßigen, sich über die gesamte Verteilung der Abtastwerte erstreckenden Gitters interpoliert werden. Die Verarbeitung ist auf diese Weise über das gesamte Bild hinweg vereinheitlicht, so dass Übergangsprobleme zwischen den Teilbereichen vermieden werden.

Bevorzugte Ausgestaltungen der vorliegenden Anmeldung sind Gegenstand der abhängigen Patentansprüche.

Bevorzuge Ausführungsbeispiele der vorliegenden Anmeldung werden nachfolgend Bezug nehmend auf die beigefügten Zeichnungen näher erläutert. Es zeigen:
Fig. 1 eine schematische Darstellung einer Bildaufnahmevorrichtung gemäß einem Ausführungsbeispiel der vorliegenden Anmeldung;
Fig. 2 eine schematische Darstellung einer Bildaufnahmevorrichtung gemäß einem weiteren, etwas detaillierteren Ausführungsbeispiel der vorliegenden Anmeldung;
Fig. 3a eine schematische Darstellung einer Verteilung der Bildpunkte gemäß ihrer Abbildungswerte gemäß einem Ausführungsbeispiel der vorliegenden Anmeldung, bei der als die Abbildungswerte laterale Abbildungsorte in einer Schärfentiefenfläche verwendet werden;
Fig. 3b eine schematische Darstellung einer Verteilung der Bildpunkte gemäß einem Ausführungsbeispiel der vorliegenden Anmeldung, wonach als die Abbildungswerte Abbildungsrichtungen verwendet werden, entlang denen die Optik die Abbildung auf die jeweiligen Bildpunkte vornimmt;
Fig. 4 eine Schnittansicht einer Anordnung aus Bildsensor und Mikrolinsenarray gemäß einem Ausführungsbeispiel;
Fig. 5a und 5b schematische Darstellungen zur Veranschaulichung der Blickfelder und Blickrichtungen einzelner Pixel;
Fig. 6 eine Raumansicht zur Veranschaulichung von Blickrichtungen der Bildpunkte innerhalb eines Teilbereichs inklusive einer Verzerrung gemäß einem Ausführungsbeispiel;
Fig. 7 eine schematische Ansicht einer Bildpunktwolke und eines darüber gelegten regelmäßigen Gitters gemäß einem Ausführungsbeispiel; und
Fig. 8 eine schematische Zeichnung zweier Aufnahmesituation zur Veranschaulichung des entstehenden Fehlers bei fälschlicher Ignorierung des Parallax-Effektes.

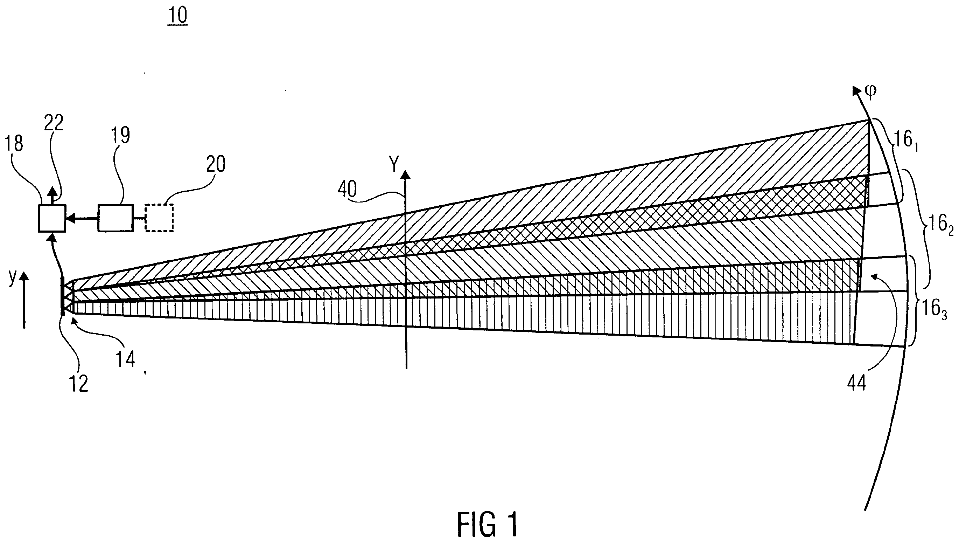

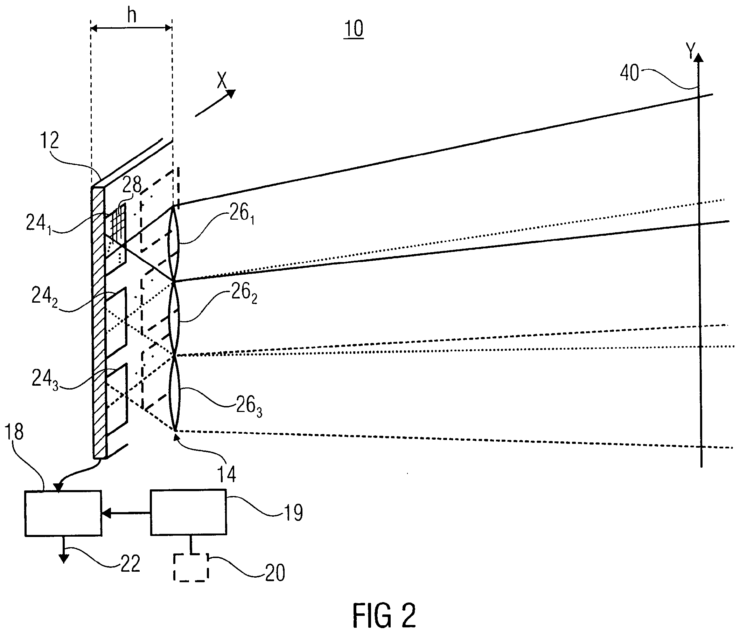

Fig. 1 zeigt eine Bildaufnahmevorrichtung gemäß einem Ausführungsbeispiel der vorliegenden Anmeldung. Die Bildaufnahmevorrichtung von Fig. 1 ist allgemein mit dem Bezugszeichen 10 angezeigt und umfasst einen Bildsensor 12 mit einer Vielzahl von Bildpunkten, die erst in Fig. 2 exemplarisch gezeigt sind, und einer Optik 14 zur Erzeugung einer optischen Abbildung auf dem Bildsensor 12, wobei die Optik eine Mehrkanaloptik zum individuellen Abbilden sich überlappender Raumwinkelbereiche 16₁, 16₂ und 16₃ auf separate Teilbereiche des Bildsensors umfasst, welche letztere ebenfalls erst in Fig. 2 angedeutet werden. Die Bildaufnahmevorrichtung 10 von Fig. 1 umfasst ferner einen Interpolator 18 sowie - optional - weitere Komponenten, wie z.B. einen Zuordner 19 und eine Benutzereingabeschnittstelle und/oder einen Entfernungsmesser 20.

Der Bildsensor 12 ist mit dem Interpolator 18 verbunden, und ist ausgebildet, um in einer Aufnahme einen Abtastwert, wie z.B. einen Helligkeitswert, pro Bildpunkt zu erfassen und an den Interpolator 18 auszugeben. Die optionale Eingabeschnittstelle und/oder der optionale Entfernungsmesser 20 sind optional über den Zuordner mit dem Interpolator 18 verbunden. Wie es im Folgenden noch näher erörtert werden wird, ist es über die optionale Eingabeschnittstelle oder den Entfernungsmesser 20 in Zusammenarbeit mit dem Zuordner 19 möglich, dass der Interpolator 18 bei der später noch näher zu erörternden Interpolation die Entfernung berücksichtigen kann, die die Objekte einer Szene aufweisen, die sich in dem durch die überlappende Raumwinkelbereiche 16₁-16₃ gebildeten Gesamtgesichtsfeld befinden und auf die jeweiligen Teilbereiche des Bildsensors 12 abgebildet werden. An einem Ausgang 22 der Bildaufnahmevorrichtung 10 gibt der Interpolierer 18 das gewünschte Bild in Form eines Arrays von Bildwerten aus.

Nachdem nun im Vorhergehenden der Aufbau der Bildaufnahmevorrichtung von Fig. 1 beschrieben worden ist, wird im Folgenden ihre Funktionsweise näher beschrieben. Dabei wird im Folgenden auch manchmal auf Fig. 2 Bezug genommen, die die gleichen Komponenten wie aus Fig. 1 gezeigt, jedoch mit einem erhöhten Detaillierungsgrad gemäß einem Ausführungsbeispiel der vorliegenden Anmeldung.

Wie bereits im Vorhergehenden erwähnt, weist die Optik 14 eine Mehrkanaloptik zum individuellen Abbilden sich überlappender Raumwinkelbereiche 16₁-16₃ auf separate Teilbereiche 24₁-24₃ des Bildsensors 12 auf. Wie es in den Figuren 1 und 2 angedeutet ist, kann es sich bei der Mehrkanaloptik um ein Linsenarray aus Mikrolinsen 26₁-26₃ handeln, von denen jede einem jeweiligen der Teilbereiche 24₁-24₃ zugeordnet ist, um einen entsprechenden Kanal mit einem jeweiligen Blickfeld bzw. Raumwinkelbereich 16₁-16₃ zu bilden. In dem exemplarischen Fall von Fig. 1 und 2 ist die Mehrkanaloptik so ausgebildet, dass die sich überlappenden Raumwinkelbereiche 16₁-16₃ zusammen einen Gesamtraumwinkelbereich abdecken, der deutlich größer ist als die sich gegenseitig überlappenden Raumwinkelbereiche allein genommen, wie z.B. 4 mal größer als jeder der sich überlappenden Raumwinkelbereiche 16₁-16₃. Wie bereits in der Beschreibungseinleitung der vorliegenden Anmeldung erwähnt, kann auf diese Art und Weise eine Aufbauhöhe h, die im Wesentlichen einem Abstand der Optik 14 von dem Bildsensor 12 entspricht und etwa gleich oder etwas größer als eine Brennweite der Mikrolinsen ist, verkleinert werden. Erzielt wird nämlich der insgesamt vergrößerte Gesamtblickwinkel, indem beispielsweise ein Mittenabstand der Mikrolinsen 26₁-26₃ bzw. ein mittlerer Abstand der Scheitel der Mikrolinsen 26₁-26₃ gegenüber einem Mitten- bzw. Wiederholabstand der Teilbereiche 24₁-24₃ des Bildsensors 12 vergrößert wird. Auf diese Weise tritt eine Entkopplung des gewünschten Gesamtgesichtsfeldes der Bildaufnahmevorrichtung von der Aufbauhöhe h ein. In anderen Worten ausgedrückt kann durch Aufteilung des Gesamtgesichtsfeldes in die Einzelgesichtsfelder 16₁-16₃ die Aufbauhöhe h gegenüber einem Aufbau mit einer Einzeloptik reduziert werden, und zwar um so mehr, je größer die Anzahl der Teilbereiche ist. Aufgrund des notwendigen Abstandes zwischen den Linsen bzw. der Größe der Linsen im Verhältnis zu den kleineren Teilbereichen kann die Aufteilung in einzelne Kanäle allerdings in der Realität begrenzt sein. Beispielsweise liegt eine Anzahl der Kanäle zwischen 4 und 10000.

Schließlich wird, bevor mit der Beschreibung der Funktionsweise fortgefahren wird, darauf hingewiesen, dass es anders als in den nächsten Ausführungsbeispielen dargestellt, auch möglich wäre, den Wiederholabstand der Mikrolinsen 26₁-26₃ kleiner einzustellen als den mittleren Wiederholabstand der Teilbereiche 24₁-24₃, und zwar derart, dass die Raumwinkelbereiche sich im Wesentlichen vollständig überlappen. Beispielsweise könnte der Gesamtraumwinkelbereich so klein sein, dass er höchstens 120% größer ist als jeder der sich überlappenden Einzelraumwinkelbereiche.

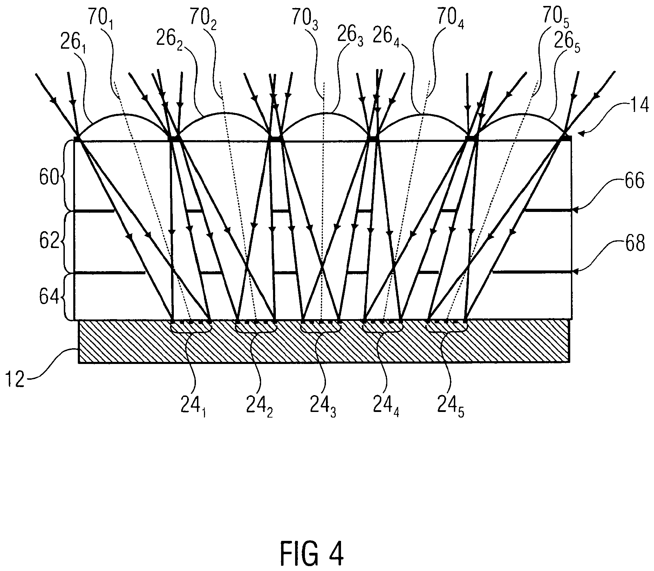

Wie es bereits erwähnt worden ist, weist der Bildsensor 12 eine Vielzahl von Bildpunkten 28 auf. Dabei umfasst wiederum insbesondere jeder der Teilbereiche 24₁-24₃ eine Vielzahl dieser Bildpunkte 28 auf. Beispielsweise umfasst jeder Teilbereich 24₁-24₃ 32 oder mehr Bildpunkte. Wie es noch später Bezug nehmend auf Fig. 4 beschrieben werden wird, kann es sich bei dem Bildsensor 12 beispielsweise um einen Ein-Substrat-Bildsensor handeln, in welchem die Teilbereiche 24₁-24₃ gemeinsam gebildet sind, wobei Zwischenräume zwischen diesen Teilbereichen 24₁-24₃ dazu verwendet werden können, Ansteuerungsschaltungsteile zur Ansteuerung der photoempfindlichen Bereiche der Bildpunkte 28 unterzubringen wie z.B. Leseverstärker, Zeilen- und/oder Spaltendecoder usw.

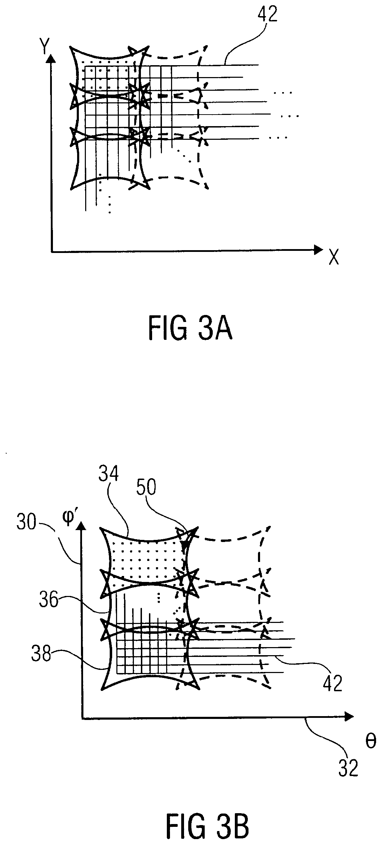

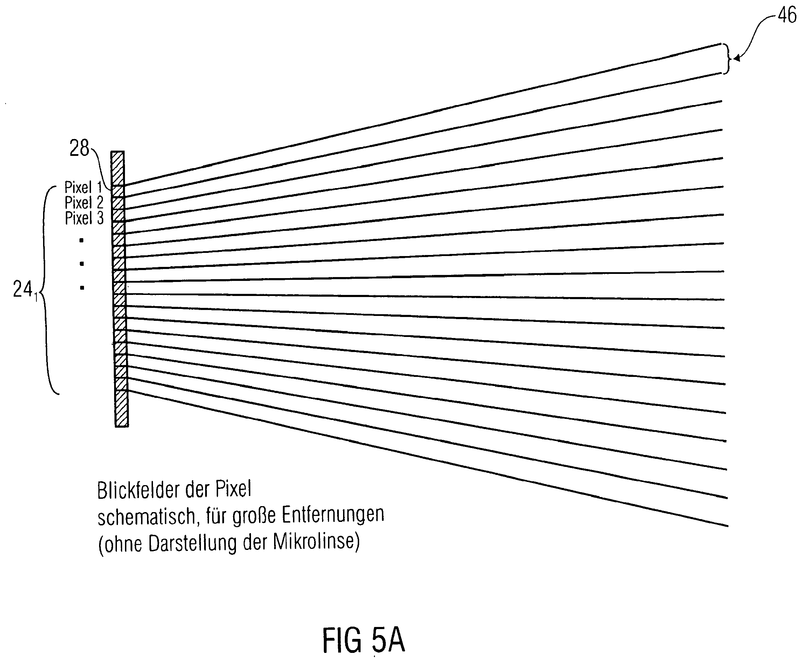

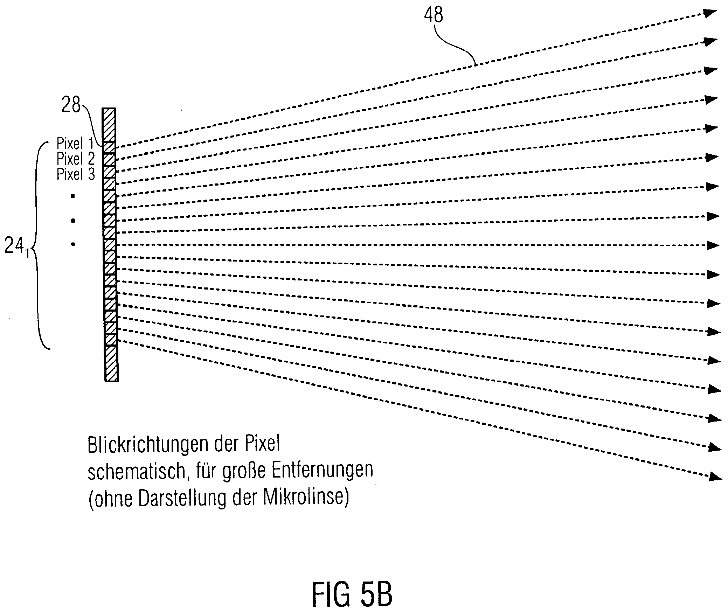

Genauso, wie den Teilbereichen 24₁-24₃ durch die relative Anordnung zur Optik 14 und insbesondere den Mikrolinsen 26₁-26₃ ein jeweiliger Raumwinkelbereich 16₁-16₃ zugeordnet ist, ist natürlich auch jedem Bildpunkt 28 ein jeweiliger, natürlich kleinerer Raumwinkelbereich zugeordnet und somit auch eine Blick- bzw. Abbildungsrichtung, die beispielsweise zentral zu dem jeweiligen Raumwinkelbereich des Bildpunkts verläuft. Der Zusammenhang wird später näher Bezug nehmend auf Fig. 5a und Fig. 5b erläutert. Alle Abbildungs- bzw. Blickwinkel der Abbildungs- bzw. Blickrichtungen werden beispielsweise bezogen auf eine optische Achse der Optik 14 bzw. einer Flächennormalen der photoempfindlichen Fläche des Bildsensors 12 bestimmt. Auf diese Weise ist es möglich, die Bild punkte 28 in einer Ebene anzuordnen, wie sie in Fig. 3b dargestellt ist, nämlich eine Ebene, die durch zwei Achsen aufgespannt wird, von denen eine Achse 30 die Abweichung der Abbildungsrichtung des jeweiligen Bildpunkts ϕ in einer Zeilenrichtung x der Bildpunkte 28 und eine Achse 32 beispielsweise die Winkelabweichung der Abbildungsrichtung gegenüber der optischen Achse in der zur Achse x senkrechten Spaltenrichtung y betritt, wobei letzterer Winkel mit ϑ angegeben ist. Es wird darauf hingewiesen, dass die Achsen vorzugsweise gleich skaliert bzw. isotrop sind. In Fig. 3b ist angedeutet, wie die Bildpunkte in der so aufgespannten Ebene gemäß ihren Abbildungsrichtungen angeordnet sind. Die Umrandung 34 umrandet beispielsweise die mit Punkten angedeuteten Positionen der Bildpunkte 28 des Teilbereichs 24₁. Das kissenförmige Aussehen der Umrandung 34 deutet an, dass eine Verzeichnung der Mikrolinse 26₁ beispielsweise für eine kissenförmige Verteilung der Bildpunkte 28 des Teilbereichs 24₁ in der (ϕ, ϑ)-Ebene sorgt. Der Übersichtlichkeit halber sind in Fig. 3b die Bildpunkte 28 der anderen Teilbereiche 24₂-24₃ nicht dargestellt, sondern lediglich deren Umrandungen 36 und 38, die die Ränder der jeweiligen Teilbildpunktwolken darstellen. Zudem deutet Fig. 3b an, wo sich die Bildpunkte von Teilbereichen befinden, die beispielsweise in der x-Richtung benachbart zu den Teilbereichen 24₁-24₃ positioniert sein können, und die in Fig. 2 mit gestrichelten Linien angedeutet sind.

Wenn die Szene, die durch die Bildaufnahmevorrichtung 10 aufgenommen wird, weit genug entfernt ist, dann reicht es aus, wie im Vorhergehenden beschrieben lediglich die Blickrichtung zu betrachten, die jedem Bildpunkt 28 zugeordnet ist. Parallax-Effekte, die aufgrund der Tatsache auftreten, dass die Bildbereiche 24₁-24₃ und die zugehörigen Mikrolinsen zueinander lateral versetzt sind, fallen bei großen Entfernungen nicht ins Gewicht. Das ist anders bei kürzeren Entfernungen. Fig. 1 zeigt beispielsweise eine Schärfentiefefläche 40 als eine Ebene, die sich senkrecht zur optischen Achse der Optik 14 erstreckt, ebenso wie Fig. 2 diese Schärfentiefefläche zeigt. Es sei noch mal darauf hingewiesen, dass aufgrund der Tatsache, dass die aufgenommene Szene in mehrere Kanäle aufgeteilt wird, die Schärfentiefe der Optik 14 sehr hoch ist. Auf diese Weise ist es möglich, dass die Mikrolinsen 26₁-26₃ Objekte in einem sehr großen Schärfentiefenbereich, d.h. innerhalb eines sehr großen Abstandsbereiches von der Optik 14, scharf auf den Bildsensor 12 abbilden. Mikrolinsen 26₁-26₃ können beispielsweise in einem solchen Abstand zu der photoempfindlichen Fläche des Bildsensors 12 positioniert sein, dass dieser Abstand entweder gleich oder geringfügig größer als eine Brennweite der Mikrolinsen 26₁-26₃ ist.

Ebenso wie nun jedem Bildpunkt 28 eine Abbildungsrichtung zugeordnet werden kann, kann auch jedem Bildpunkt eine laterale Abbildungsposition in der transversal verlaufenden Schärfentiefenfläche 40 zugeordnet werden, nämlich diejenige, die die Optik 14 auf den jeweiligen Bildpunkt 28 abbildet. Wie es nun in Fig. 3a gezeigt ist, können die Bildpunkte 28 gemäß ihrer lateralen Abbildungsposition in einer Ebene angeordnet werden, die durch eine kartesische Koordinate in der Richtung x und eine kartesische Koordinate in der Richtung y aufgespannt wird. Wie auch in dem Fall von Fig. 3b sind in Fig. 3a durch Punkte lediglich die Positionen der Bildpunkte 28 für den Teilbereich 24₁ einzeln angedeutet, wohingegen durchgezogene Linien global die Lage bzw. Ausdehnung der Wolke von Positionen der Bildpunkte der Teilbereiche 24₂-24₃ andeuten sowie gestrichelte Linien eine Lage der Bildpunkte möglicher weiterer Teilbereiche, die in Fig. 2 mit gestrichelten Linien angezeigt sind. Auch in Fig. 3a deutet eine kissenförmige Ausgestaltung der Umrandungslinien an, dass die Einzelkanaloptiken der Optik 14 Verzerrungen hervorrufen können.

Wie im Vorhergehenden erwähnt, sind der Bildsensor 12 und die Optik 14 in einem festen Abstand zueinander angeordnet. Natürlich wäre eine variable Einstellmöglichkeit des Abstandes zwischen Bildsensor 12 und Optik 14 ebenfalls möglich, um den Schärfentiefenbereich einstellen zu können, aber wie im Vorhergehenden erwähnt, ist aufgrund der Tatsache, dass aufgrund der Verwendung der Mehrkanaloptik und der verkleinerten Aperturen der Mikrolinsen der Schärfentiefenbereich ohnehin so groß, dass eine Nachjustierung meist nicht notwendig ist. Wenn nun die Bildaufnahmevorrichtung 10 dafür ausgelegt ist, Bilder von Objekten aufzunehmen, die in Entfernungen angeordnet sind, bei denen die Parallax-Effekte noch keine Rolle spielen, dann kann es sein, dass die in Fig. 3b dargestellte Zuordnung der Abbildungsrichtungen zu den einzelnen Bildpunkten 28 der Teilbereiche 24₁-24₃ fest eingestellt ist. Der Zuordner 19 müsste in diesem Fall nicht unbedingt vorhanden sein. Die Zuordnung könnte vielmehr in dem Programmcode fest einprogrammiert sein, der die Funktion des Interpolierers 18 implementiert, oder fest verdrahtet sein. Alternativ könnte der Zuordner 19 in Form einer Nachschlagtabelle als Speicher vorhanden sein. Ebenfalls möglich wäre die Ausgestaltung des Zuordners 19 als Recheneinheit, die die Abbildungsrichtungen der einzelnen Bildpunkte 28 für jede Aufnahme neu berechnet.

Natürlich wäre es ebenfalls möglich, dass die Bildaufnahmevorrichtung 10 von Fig. 1 dazu ausgelegt ist, nur Objekte in einem bestimmten Nahbereich aufzunehmen, wie z.B. einen Nahbereich von in etwa einem halben Meter. In diesem Fall könnte die vorerwähnte Zuordnung gemäß Fig. 3a fest in dem Interpolierer 18 eingebaut sein, und der Zuordner 19 könnte fehlen. Alternativen, wie sie im Vorhergehenden bezogen auf die Zuordnung gemäß Fig. 3b beschrieben worden sind, wären aber natürlich ebenfalls möglich.

Die Zuordnungen gemäß Fig. 3b und 3a könnten nach Zusammenbau der Bildaufnahmevorrichtung beispielsweise mittels Aufnahme von geeigneten Kalibrierungsobjekten ermittelt werden. Alternativ könnte die Ermittlung der Zuordnung von Abbildungsrichtung bzw. lateraler Abbildungsposition in der Schärfentiefenfläche 40 durch Berechnung anhand der Designparameter der Bildaufnahmevorrichtung 10 bzw. insbesondere des Bildsensors 12 der Optik 14 und deren Lage zueinander bestimmt werden. Bei beiden Alternativen würden die Verzerrungen durch die Optik 14 mit berücksichtigt werden können.

Natürlich wäre es auch möglich, dass die Bildaufnahmevorrichtung 10 zu sowohl Aufnahmen vorgesehen ist, bei denen Parallax-Effekte aufgrund des lateralen Versatzes zwischen den Teilbereichen bzw. Aperturen eine Rolle spielen, sowie für Aufnahmen, bei denen dies nicht der Fall ist. In diesem Fall könnte die Benutzereingabeschnittstelle 20 durch einen Benutzer verwendet werden, um dem Zuordner 19 vorzugeben, ob die Zuordnung gemäß Fig. 3b, d.h. für Fernaufnahmen, oder gemäß Fig. 3a, d.h. für Nahaufnahmen durchgeführt werden soll. Eine Vorgabe durch einen Entfernungsmesser 20 wäre ebenfalls möglich, wobei der Entfernungsmesser die Entfernung vermittels Laufzeitmessung oder dergleichen ermitteln kann, oder aber durch Analyse der in den Teilbereichen vorliegenden Informationen selbst, wie z.B. Korrelation. Der Übergang zwischen der Zuordnung gemäß Fig. 3b und 3a muss auch nicht abrupt erfolgen. Vielmehr verschwindet der Parallax-Term ohnehin kontinuierlich mit größer werdendem Abstand der Szene von der Optik 14. Somit wäre es ebenfalls möglich, dass der Zuordner 19 von der Eingabeschnittstelle/dem Entfernungsmesser 20 eine Entfernungsangabe des aufzunehmenden Objekts erhält und dementsprechend die Zuordnung unter Berücksichtigung des Parallax-Terms durch Nachschlagen mittels der Entfernungsangabe oder durch Berechnung unter Verwendung der Entfernungsangabe einstellt.

Der Interpolierer 18 ist nun dazu da, aus der gemeinsamen Punktwolke aller Bildpunkte 28 in der Ebene gemäß Fig. 3b bzw. Fig. 3a ein Array von Bildpunkten, d.h. ein regelmäßiges Gitter von Bildwerten zu erzeugen, d.h. das gewünschte Bild. Dazu legt der Interpolierer 18 ein regelmäßiges Gitter 42 über die Vereinigung aller Einzelpunktwolken der Teilbereiche, d.h. über die gesamten Einzelbilder mit den Bildpunkten gemäß Abbildungswerten angeordnet, und interpoliert zwischen den Abtastwerten der Bildpunkte an den Positionen in der Ebene gemäß Fig. 3a oder Fig. 3b, nämlich an den Positionen der Kreuzungspunkte des regelmäßigen Gitters 42. Es sei darauf hingewiesen, dass es möglich ist, dass das regelmäßige Gitter mehr Kreuzungspunkte aufweist als Stützstellen, d.h. mehr Kreuzungspunkte als Bildpunkte 28. Die Kreuzungspunkte des regelmäßigen Gitters 42, die zum gewünschten Bildarray beitragen, sollten allerdings innerhalb der gemeinsamen Menge aller Bildpunkte liegen, da sonst eine Extrapolation mit der damit verbundenen Ungenauigkeit notwendig wäre. Ein Beispiel für ein Interpolationsverfahren wird im Folgenden geliefert. Allerdings existieren eine Vielzahl möglicher Interpolationsverfahren, die verwendet werden können. Die Abbildungswerte können jedenfalls in vorteilhafter Weise in einer skalaren Genauigkeit mit einer kleinsten Einheit vorliegen, die mindestens 16 mal größer ist als ein Gitterabstand des regelmäßigen Gitters. In anderen Worten ausgedrückt kann der Interpolierer 18 in dem Raum gemäß Fig. 3a oder 3b die dort auftretenden Komponenten mit einer ersten Bitgenauigkeit handhaben, und bezogen auf dieselbe liegen die Kreuzungspunkte des Gitters 42 mindestens 16 kleinste Einheiten entfernt. Die Interpolation kann somit für alle Einzelbilder einheitlich in einem Schritt ablaufen, was sich beispielsweise darin niederschlagen kann, dass pro Gitterpunkt auch in den Überlappbereichen der Einzelbilder bzw. Einzelbildpunktwolken nur eine Interpolation durchgeführt wird, an der alle Einzelbilder, die sich in dem jeweiligen Überlappbereich überlappen, gleichermaßen partizipieren. Ein Umjustieren bzw. Manipulieren der Abbildungswerte ist nicht erforderlich. Einmal ermittelt gehen Sie beispielsweise nur in Gewichtungswerte ein, mit denen die Strahldichtewerte der Bildpunkte zu einem jeweiligen interpolierten Wert kombiniert werden, indem nämlich, wie es im folgenden noch veranschaulicht wird, die Gewichtung beispielsweise gleich einem geeigneten Abstandmaß zwischen dem betrachteten Kreuzungsgitterpunkt, an dem gerade interpoliert werden soll, und dem jeweiligen umliegenden Bildpunkt ist.

Die vorhergehende Beschreibung ging nicht darauf ein, dass die Bildpunkte 28 möglicherweise ein ungleiches Empfindlichkeitsverhalten aufweisen. Ihre Empfindlichkeit kann sich beispielsweise spektral, hinsichtlich Polarisation des eintreffenden Lichts oder hinsichtlich der (Neutraldichte-) Empfindlichkeit unterscheiden. In diesem Fall wäre es möglich, dass der Interpolierer 18 die Bildpunkte gleicher Empfindlichkeitscharakteristik wie im Vorhergehenden beschrieben in den Ebenen gemäß Fig. 3a bzw. 3b anordnet und darüber einzeln das Gitter 42 legt, um zu einem regelmäßigen Bildarray getrennt für diese Empfindlichkeitscharakteristik zu gelangen, wobei dieses Vorgehen dann für alle Empfindlichkeitscharakteristiken bzw. für die Bildpunkte alle Empfindlichkeitscharakteristiken getrennt nach Empfindlichkeitscharakteristik durchgeführt würde. Wie es im Folgenden noch erwähnt werden wird, ist es dabei möglich, dass die Interpolation der jeweiligen Teilverteilung von Bildpunkten gleicher Empfindlichkeitscharakteristik dadurch verbessert werden kann, dass die Bildpunkte anderer Empfindlichkeitscharakteristik ebenfalls berücksichtigt werden. Auf diese eben beschriebene Art und Weise wäre es möglich, ein Farbbild zu erhalten. Ein Vorteil dieser Vorgehensweise besteht darin, dass das Gitter 42 für alle Empfindlichkeitscharakteristiken in der Ebene gemäß Fig. 3a bzw. 3b exakt an der gleichen Stelle liegen kann, so dass alle Farbkomponenten für eine Position des gemeinsamen Farbbildarrays exakt die gleiche Stelle betreffen. Bei normalen Farbaufnahmen mit einem Farbbildsensor ist dies nicht so, da die Komponenten einer Subpixelzelle lateral an unterschiedlichen Stellen abgetastet werden. In den Teilbereichen 24₁-24₃ der Bildaufnahmevorrichtung 10 ist dies zwar ebenfalls der Fall, aber durch die Interpolation werden die einzelnen Teilbildpunktwolken der einzelnen Empfindlichkeitscharakteristiken exakt an der gleichen Stelle interpoliert. Wenn, wie soeben erwähnt, auch noch die Bildpunkte der anderen Empfindlichkeitscharakteristiken zur Verbesserung der Interpolation verwendet werden, ergibt sich eine noch bessere Bildqualität.

Allerdings ist es ebenfalls möglich, dass bei der Bildaufnahmevorrichtung 10 jeder Kanal für sich genommen einheitlich gefiltert ist, wie z.B. spektralgefiltert, neutraldichtegefiltert oder polarisationsgefiltert, aber verschiedene Kanäle können unterschiedliche Filtercharakteristik aufweisen. In diesem Fall könnten die Raumwinkelbereiche so vorgesehen sein, dass für jede Filtercharakteristik die Kanäle, die zu dieser Filtercharakteristik gehören, das Gesamtblickfeld der Bildaufnahmevorrichtung 10 abdecken, so dass sich für alle diese Filtercharakteristiken eine Gesamtbildwolke gemäß Fig. 3a bzw. 3b ergibt. Wieder kann der Interpolierer 18 in diesem Fall für jede dieser Teilbildpunktwolken für die unterschiedlichen Filtercharakteristiken getrennt eine Interpolation an den Gitterkreuzungspunkten des regelmäßigen Gitters 42 durchführen, um auf diese Weise zu einem regelmäßigen Bildarray mit mehrkomponentigen Bildinformationen zu gelangen, wie z.B. zu einem Farbbild.

Nachdem nun im Groben die Funktionsweise und der Aufbau von Ausführungsbeispielen gemäß der vorliegenden Anmeldung beschrieben worden sind, wird im Folgenden noch auf Möglichkeiten eingegangen, die einzelnen Komponenten zu gestalten, die im Vorhergehenden erwähnt worden sind. Wie es aus der folgenden Beschreibung hervorgehen wird, kann es sich bei dem Bildsensor 12 beispielsweise um einen CMOS-Bildsensor handeln, bei dem die Teilbereiche 24₁-24₃ beispielsweise gemeinsam auf einem Substrat bzw. Chip integriert sind. Durch Waferbonden oder Abformung kann die Mehrkanaloptik direkt auf dem Chip selbst integriert werden bzw. getrennt von einer Oberfläche des Substrats durch semitransparente Schichtenanordnungen, die für eine optische Transparenz zwischen den Teilbereichen 24₁-24₃ und den Aperturen sorgen, aber für eine optische Trennung der einzelnen Kanäle untereinander.

Der Interpolierer 18 könnte auf dem gleichen Chip bzw. Substrat integriert sein, auf dem auch der Bildsensor 12 integriert ist. Der Interpolierer 18 könnte hartverdrahtet sein, eine programmierbare Schaltungslogik oder ein Computerprogramm, das auf einem Prozessor abläuft. Insbesondere kann es sich bei dem Interpolierer 18 aber auch um einen Computer handeln, der mit dem Bildsensor 12 verbunden ist.

Der Zuordner 19 kann beispielsweise ein nicht-flüchtiger Speicher sein, wie z.B. ein EEPROM oder dergleichen. Bei der Bildeingabeschnittstelle 20 kann es sich beispielsweise um einen Kippschalter mit einer ersten gekippten Stellung, einer zweiten gekippten Stellung und einer nicht-gekippten Stellung handeln, wobei die ersten beiden Stellungen eine Fern- bzw. Nahaufnahme auslösen könnten und die letztgenannte Stellung ein Ruhe- bzw. ein Don't-Care-Zustand wäre. Der Zuordner 19 würde je nach Auslösestellung die Zuordnung beispielsweise gemäß Fig. 3b oder 3a durchführen. Allerdings wäre es auch möglich, dass die Benutzereingabeschnittstelle 20 ein Drehrad wäre oder eine sonstige kontinuierlich veänderliche Benutzerschnittstelle, wie z.B. ein verstellbarer Balken in einer graphischen Benutzerschnittstelle. Im letztgenannten Fall könnte der Zuordner 19 die so getätigte Eingabe auch als kontinuierliche oder quasi-kontinuierliche Angabe der Entfernung verwenden, um diese bei der Berechnung der Zuordnung der lateralen Abbildungspositionen in der Schärfentiefenfläche 40 zu verwenden.

Wie im Vorhergehenden ebenfalls erwähnt, kann allerdings auch ein Abstandssensor 20 verwendet werden. Dieser Abstandssensor kann den Abstand der aufzunehmenden Szene auf jedwede Weise erfassen, wie z.B. durch Laufzeitmessung oder dergleichen, aber auch Schätzen, wie z.B. aus den Bildinformationen der einzelnen Teilbilder selbst. Mehr oder weniger quantisiert könnte die so erhaltene Entfernungsmessung wie im Vorhergehenden erwähnt durch den Zuordner 19 verwendet werden, um die Zuordnungsvorschrift entsprechend anzupassen.

Nachdem nun im Vorhergehenden bereits einige Ausführungsbeispiele der vorliegenden Anmeldung beschrieben worden sind, werden im Folgenden noch einige Implementierungsdetails geliefert, die möglicherweise verwendet werden könnten, um obige Ausführungsbeispiele umzusetzen.

Dabei wird zunächst noch einmal das im Vorhergehenden beschriebene in anderen Worten wiederholt. Wie es oben beschrieben worden ist, erzeugt die Optik 14 beispielsweise M x N nicht-überlappende Mikrobilder auf dem Sensor 12. Die einzelnen Kanäle der Mikrokanaloptik können beispielsweise einzelne Mikrolinsen 26₁-26₃ aufweisen. Jede Mikrolinse bildet einen Raumwinkelbereich 16₁-16₃ aus dem Objektraum auf den Sensor ab, wobei, wie es im Vorhergehenden bereits angedeutet worden ist und im Nachfolgenden noch vertieft wird, diese Vereinfachung nur für Objekte gilt, deren Entfernung groß gegenüber dem Mikrolinsenwiederholabstand ist. Die Raumwinkelbereiche 16₁-16₃ bzw. Blickfelder der einzelnen Kanäle sind nicht disjunkt, sondern überlappen sich, wie dies in Fig. 1 bei 44 gezeigt ist.

Jeder Bildpunkt 28 innerhalb eines Mikrobildes 24₁-24₃, das wiederum innerhalb des Bereiches liegt, der von der zugeordneten Mikrolinse 26₁-26₃ ausgeleuchtet wird, "sieht" einen kleinen Raumwinkel, in dem er über denselben integriert. In Fig. 5a ist dies exemplarisch sehr vereinfachend für den Teilbereich 24₁ veranschaulicht. Die Raumwinkel 46, die ein einzelner der zueinander benachbarten Bildpunkte 28 innerhalb eines Teilbereichs 24₁ einer Mikrolinse, die in Fig. 5a der Einfachheit halber nicht gezeigt ist, sieht, schließen beispielsweise lückenlos aneinander. Natürlich ist es möglich, dass aufgrund eines begrenzten Füllfaktors der Bildpunkte 28 die Bereiche 46 nicht lückenlos aneinander schließen. Zur Vereinfachung kann aber angenommen werden, dass der Wert eines Bildpunktes 28 einen Messwert für die Strahldichte darstellt, die in Richtung des Strahls in der Mitte des jeweiligen Raumwinkels 46 auf den jeweiligen Bildpunkt 28 fällt. Dies stellt dann die im Vorhergehenden erwähnte Blickrichtung 48 des jeweiligen Bildpunktes 28 dar und ist in Fig. 5b veranschaulicht.

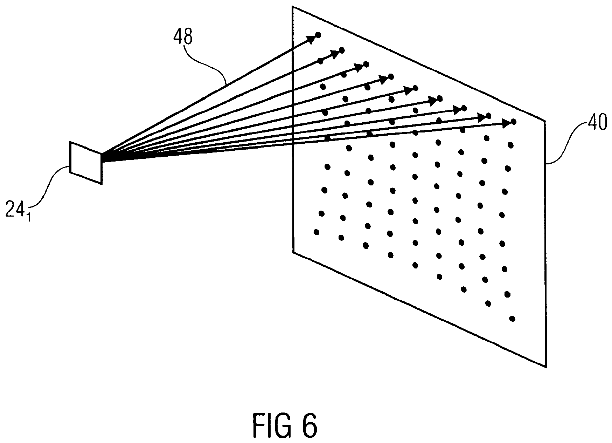

Zur Reduktion der Herstellungskosten kann es sein, dass die Mikrolinsen nicht verzeichnungsfrei sind. Die Bildpunkte tasten daher den Raum gemäß Fig. 3a bzw. 3b nicht gleichmäßig ab; das Gitter, das aus den Blickrichtungen der Pixel in Fig. 3b gebildet wird, ist somit beispielsweise nicht regelmäßig. Zusätzlich kann jede Mikrolinse 26₁-26₃ der Mehrkanaloptik eine eigene Form der Verzeichnung aufweisen, die in Fig. 6 exemplarisch für den Kanal des Bereichs 24₁ gezeigt ist.

Wie es nun im Vorhergehenden beschrieben worden ist, ist es nun aber für die Bildaufnahmevorrichtung 10 möglich, aus den Mikrobildern ein regelmäßiges ansprechendes gemeinsames Bild zu erzeugen.

In einer Ebene gemäß Fig. 3a oder 3b werden die Messwerte, d.h. die Abtastwerte der einzelnen Bildpunkte 28, für die Strahldichten aus den Bildpunkten aufgetragen. Die Koordinaten der Messwerte ergeben sich beispielsweise aus der Blickrichtung bzw. der Richtung der optischen Achse der zugehörigen Mikrolinse 26₁-26₃ bzw. des jeweiligen Kanals, den Pixelkoordinaten des jeweiligen Bildpunktes unter der jeweiligen Mikrolinse und der Verzeichnung der jeweiligen Mikrolinse und können, wie im Vorhergehenden Bezug nehmend auf Fig. 3a und 3b beschrieben, in Winkeleinheiten oder in kartesischer Form bezogen auf eine Schärfentiefenebene angegeben sein. Die genaue Form der Verzeichnung kann aus dem Optikdesign der Optik 14 ermittelt werden, jedoch auch für ein konkretes physisches System aus Sensor 12 und beispielsweise aufgeklebter Optik 14 gemessen werden.

Auf diese Weise erzeugt jede Mikrolinse bzw. jeder Teilbereich des Bildsensors eine kleine Punktwolke auf der Ebene gemäß Fig. 3a und 3b. Jeder - unendlich kleine - Punkt in der Punktwolke stellt einen Messwert der Strahldichte für eine bestimmte Blickrichtung bzw. laterale Bildungsposition in der jeweiligen Schärfentiefenebene dar. Die Strahldichte zwischen den Punkten kann zunächst als unbekannt angenommen werden.

Die Punktwolken benachbarter Mikrolinsen, die in Fig. 3a und 3b mit den Umrandungen 34 lediglich hinsichtlich ihrer Außenmaße angedeutet sind, durchdringen sich einander. Das Optikdesign des Mikrolinsensystems kann so gestaltet sein, dass die Punkte der Punktwolken nicht aufeinander fallen, sondern möglichst gleichmäßig auf der Ebene verteilt sind, d.h. auch in dem Bereich, in welchem sich die Teilbildpunktwolken der einzelnen Kanäle überschneiden, wobei ein solcher Überlappbereich in Fig. 3b mit 50 angezeigt ist.

Danach legt der Interpolierer 18 über die so gewonnene Gesamtpunktwolke wie im Vorhergehenden beschrieben ein regelmäßiges kartesisches Gitter 42. Aus den vorhandenen Messwerten wird die Strahldichte an den Kreuzungspunkten des kartesischen Gitters ermittelt bzw. interpoliert. Beispielsweise können zu jedem Kreuzungspunkt die n nächsten Nachbarn ermittelt werden, wobei deren Strahldichtewerte für eine gewichtete Mittelung verwendet werden. Die Gewichtung bzw. Norm jeden Bildpunktstrahldichtewerts kann beispielsweise mit dem Inversen des Abstandes oder dem Inversen des Quadrats des Abstandes erfolgen.

Die Ermittlung der nächsten Nachbarn kann z.B. durch Durchsuchen aller Punkte der Punktwolke erfolgen. Teilt man die Punkte vorher in verschiedene Bereiche, sogenannte Bins, auf, kann das die Suche beschleunigen. Eine schnellere Alternative ist es, zwischen den Bildpunkten der Wolke eine Triangulation aufzuspannen, optimalerweise eine Delaunay-Triangulation. Das Finden der nächsten Nachbarn eines beliebigen Punktes in einer Delaunay-Triangulation ist vergleichsweise schnell. Insbesondere kann der folgende Algorithmus, beschrieben durch einen Pseudocode, verwendet werden, um die Punktwolke zu generieren und zu interpolieren.

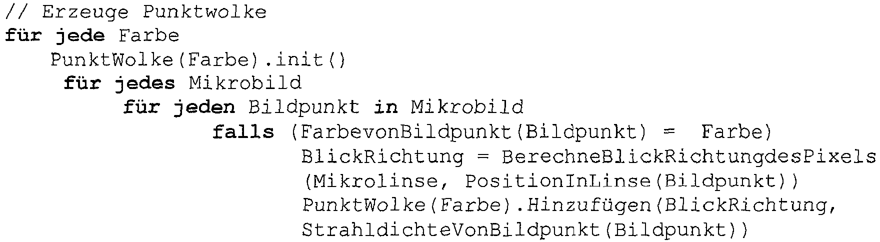

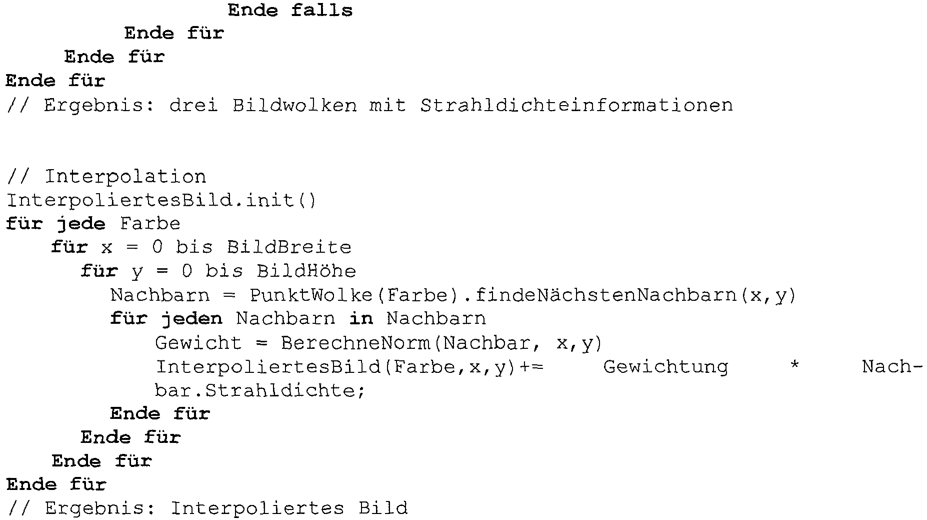

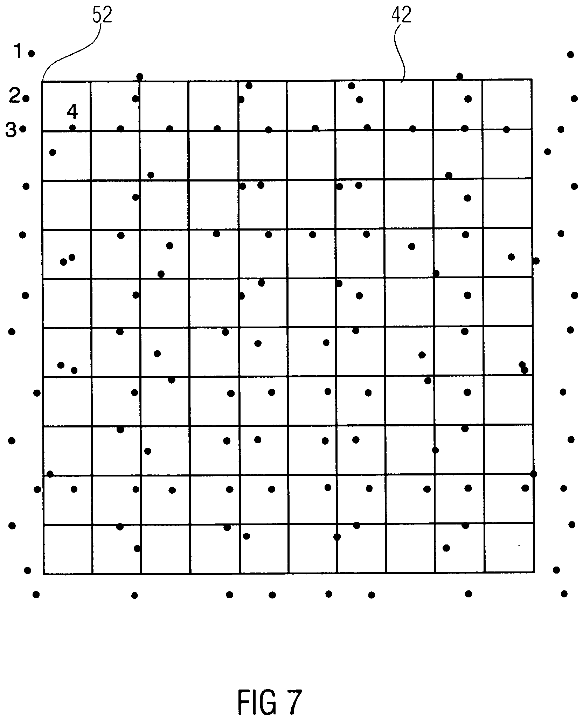

Um obigen Pseudocode zu erklären, wird wieder kurz auf obige Figuren zusammen mit Fig. 7 Bezug genommen. Die erste Für-Schleife in dem Punktwolkenerzeugungsprogrammcode geht die einzelnen Farben der Bildpunkte durch. Es wird also für jede Farbe eine Gesamtwolke erzeugt. Die zweite Für-Schleife durchläuft alle Mikrobilder 24₁-24₃. Die dritte Für-Schleife, d.h. die innerste, durchläuft alle Bildpunkte 28 in dem aktuellen Mikrobild 24₁-24₃. Durch die innerste Falls-Abfrage wird überprüft, ob der aktuell gesuchte Bildpunkt die aktuelle Farbe besitzt. Falls dies der Fall ist, wird seine Blickrichtung berechnet, und zwar unter Verwendung der Referenz auf den jeweiligen Kanal bzw. die jeweilige Mikrolinse und die Pixelposition innerhalb des Mikrobildes, und die Strahldichte des aktuell gesuchten Bildpunktes wird in der Ebene gemäß Fig. 3a bzw. 3b an der entsprechenden Stelle eingetragen. In diesem exemplarischen Fall wurde von der Blickrichtung ausgegangen, d.h. von der Ebene gemäß Fig. 3b.

Der zweite Programmabschnitt beschäftigt sich mit der eigentlichen Interpolation. Die äußerste Für-Schleife durchläuft wieder die einzelnen Farben. Für jede Farbe wird nun einmal das regelmäßige kartesische Gitter 42 durchlaufen, nämlich seine Kreuzungspunkte 52. BildBreite und BildHöhe geben somit die Bildhöhe und die Bildbreite des gewünschten Gesamtbildes an, das später am Ausgang 22 ausgegeben werden soll. Nach den entsprechenden zwei Für-Schleifen werden zunächst die Nachbarn für diesen Gitterpunkt 52 bestimmt. Die vier nächsten Nachbarn des exemplarischen in Fig. 7 angezeigten Kreuzungspunktes 52 des Gitters 42 wären beispielsweise die mit 1, 2, 3 und 4 angezeigten Bildpunkte. Die innerste Für-Schleife durchläuft all diese Nächstnachbarbildpunkte, berechnet für jeden dieser Bildpunkte eine Gewichtung gemäß einer geeigneten Abstandsnorm zum aktuellen Gitterpunkt 52 und bildet eine entsprechend gewichtete Summe der Strahldichte dieser Bildpunktnachbarn, um zu interpolierten Werten an der Stelle des aktuellen Kreuzungspunktes 52 zu gelangen. Auf diese Weise wird für alle Kreuzungsgitterpunkte 52 ein interpolierter Wert bestimmt, und zwar für alle Farben, so dass für ein Gitter 42 für jeden Gitterkreuzungspunkt 52 ein mehrkomponentiger Farbwert entsteht.

Im Folgenden werden noch ein paar Alternativen zu der bisherigen Beschreibung erwähnt. Wie es im Vorhergehenden beschrieben worden ist, kann jeder Kanal individuell gefiltert sein. Es ist aber auch möglich, dass der Bildsensor 12 mit einem geeigneten Farbfilterarray abgedeckt ist, wie z.B. gemäß einem Bayer-Muster. Auf diese Weise kann die spektrale Strahldichte des Gesamtbildes für einige, üblicherweise drei Wellenlängen-Bänder gemessen werden. Die Dichte der Messpunkte in einem einzelnen Band sinkt naturgemäß. Bei einem Bayer-Muster ist sie für Grün halbiert und für Rot und Blau geviertelt. Wie im Vorhergehenden beschrieben wird dann beispielsweise eine Punktwolke pro Farbkanal erzeugt. Aus der entsprechenden Interpolation in der Grün-Punktwolke ergibt sich der Grünkanal des fertigen Bildes, analog für Rot und Blau. Zusammen ergeben die Kanäle das fertige Farbbild.

Als Verbesserung ist es möglich, dass die Messpunkte aus dem Grünkanal zur Interpolation der Rot- und Blaukanäle herangezogen werden und umgekehrt.

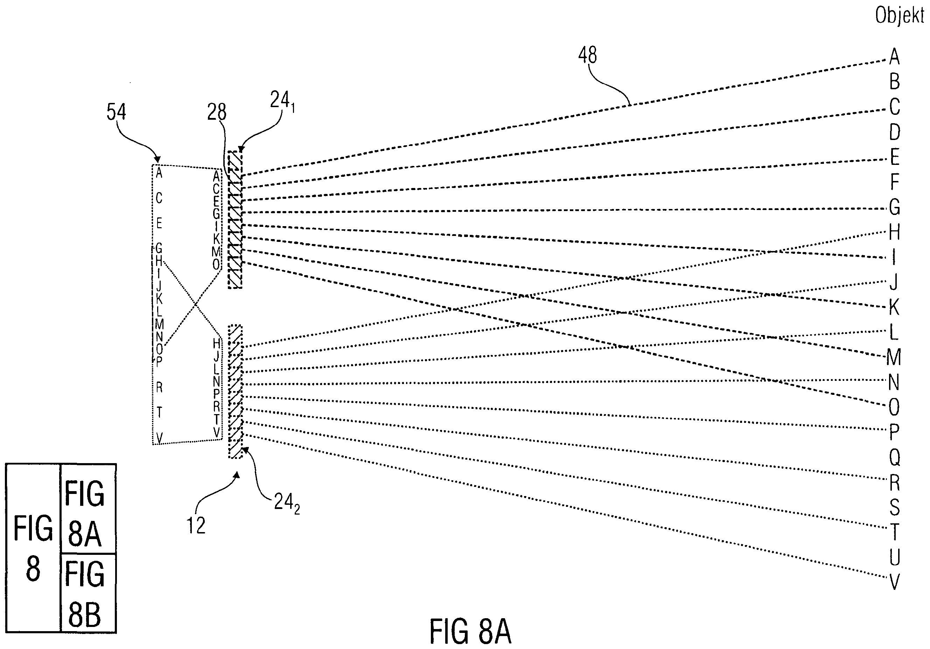

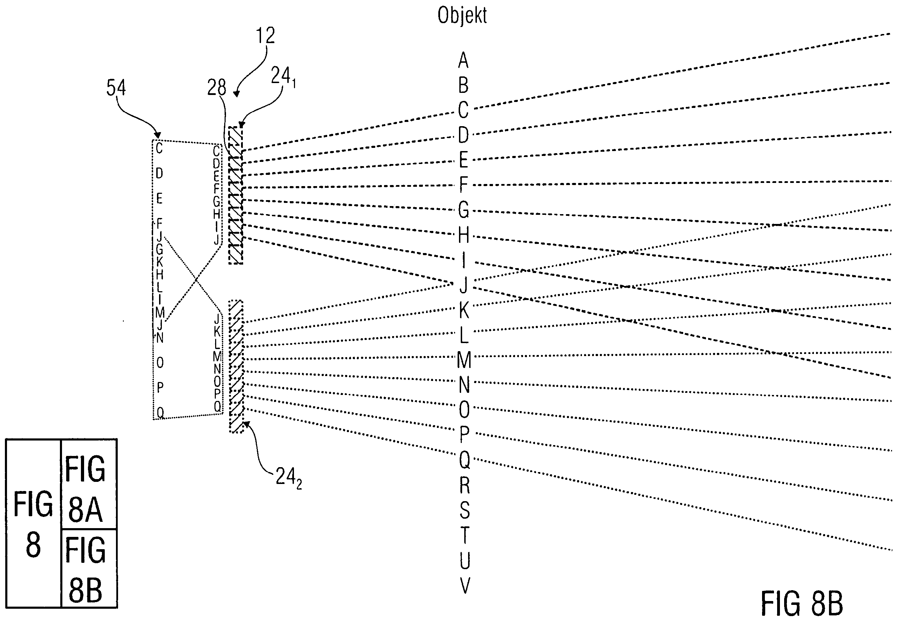

Wie es ebenfalls im Vorhergehenden bereits beschrieben worden ist, können Parallax-Effekte dafür verantwortlich sein, dass, wenn die Entfernung des abzubildenden Objekts nicht groß gegenüber dem Mikrolinsenwiederholabstand ist, die Vereinfachung nicht mehr zutrifft, wonach der Parallax-Term vernachlässigbar ist. Zusätzlich zur Blickrichtung 48 eines Pixels ist in diesem Fall auch dessen Position auf dem Bildsensor relevant. Um dies zu veranschaulichen, sei noch kurz auf Fig. 8 Bezug genommen, die oben den Fall veranschaulicht, dass das Objekt korrekt im Fernabstand angeordnet ist, d.h. das Objekt ausreichend weit vom Bildsensor 12 angeordnet ist und auch angenommen wird, dass das aufzunehmende Objekt in diesem Fernabstand angeordnet ist, d.h. die Zuordnung gemäß Fig. 3b verwendet wird, wobei unten der Fall veranschaulicht ist, dass das Objekt zu nah angeordnet ist, obwohl angenommen wird, dass es im Fernabstand positioniert ist. Bei 54 ist jeweils veranschaulicht, wie die abgetasteten Punkte A-V des Objektes an den Stellen, an denen das Objekt durch die Blickrichtungen 48 getroffen wird, im fertigen Bild umsortiert werden. Wie es zu sehen ist, bleibt die Reihenfolge der Punkte A-V auf dem Objekt in dem Fall der korrekten Positionierung des Objektes in dem fertigen Bild bestehen, wohingegen in dem Fall der inkorrekten Anordnung, d.h. zu nah am Bildsensor 12, die Reihenfolge der Objektpunkte durcheinander gerät.

Der Interpolierer 18 ist somit in der Lage, ein ansehnliches, hochaufgelöstes Bild ohne Diskontinuitäten zusammenzusetzen, wenn obige Ausführungsbeispiele verwendet werden. Messwerte von nebeinanderliegenden Punkten auf einem Objekt bleiben auch im fertigen Bild nebeneinanderliegen, solange die Bildaufnahmevorrichtung vorgabemäßig verwendet wird bzw. obige Einstellungsmöglichkeiten verwendet werden. In noch mal anderen Worten ausgedrückt, kann die Objektentfernung einer Anordnung der Messpunkte auf der Bildebene zu berücksichtigen sein. Im einfachsten Fall kann eine feste Objektentfernung angenommen werden. Denkbar ist außerdem eine Entfernungsschätzung bzw. -messung und eine dementsprechende Behandlung der Messpunkte, wie es im Vorhergehenden beschrieben worden ist.

Im Vorhergehenden bezog sich die Beschreibung vornehmlich auf eine Bildaufnahmevorrichtung mit Blickfeldvergrößerung durch Aufteilung in mehrere Kanäle mit kleineren Blickwinkeln, die sich gegeneinander überschneiden. Die vorliegende Anmeldung ist dabei auch für andere Anwendungen denkbar, bei denen beispielsweise eine Szene aus unterschiedlichen Blickwinkeln mit sich im Wesentlichen überlappenden Einzelkanalbildfeldern betrachtet wird.

Bei den obigen Ausführungsbeispielen kann für die Mehrkanaloptik ein gechirptes Mikrolinsenarray verwendet werden, d.h. ein Mikrolinsenarray, dessen Linsenscheitel laterale Positionen aufweisen, die gegenüber den Mittenpositionen der entsprechenden Teilbereiche beispielsweise zentrisch gestreckt positioniert oder anders verschoben sind. Fig. 4 zeigt exemplarisch ein mögliches Beispiel für eine feste Anordnung mit festem Abstand zwischen Bildsensor 12 und Mikrolinsenarray 14. Der Bildsensor 12 ist beispielsweise ein CMOS-Bildsensors oder ein anderer Halbleitersensor. Auf dem Substrat 12 sind mehrere Glassubstrate 60, 62 und 64 mit dazwischen angeordneten Membranarrays 66 und 68 zur Kanaltrennung und Streulichtabsorption angeordnet. Auf dem obersten Glassubstrat 60 sind die Mikrolinsen 26₁-26₅ gebildet. Wie es zu ersehen ist, ist der Scheitelwiederholabstand der Mikrolinsen größer als der Mittenwiederholabstand der Teilbereiche 24₁-24₅, wodurch die Vergrößerung des Gesamtblickfeldes bzw. das Auseinanderlaufen der zentralen Blickrichtungen 70₁-70₅ der einzelnen Kanäle entsteht. Das Beispiel für einen Aufbau gemäß Fig. 4 kann beispielsweise im Wafer-Verbund hergestellt werden, nämlich mit anschließendem Dicen der einzelnen Kameras, d.h. den einzelnen Verbünden aus Bildsensor und Mikrolinsenarray.

Im Rahmen einer plenoptischen Kamera könnten obige Ausführungsbeispiele auch verwendet werden, indem bei den oben gezeigten Ausführungsbeispielen dem Mikrolinsenarray eine Primäroptik hinzugefügt wird.

Zu obigen Ausführungsbeispielen sei noch erwähnt, dass die Kanäle der oben gezeigten Mikrolinsenarrays gleich sein können oder zueinander in lateraler Richtung bzw. über das Feld hinweg unterschiedlich bzw. gechirpt sein können. Ein Kanal kann wiederum von einer Einzellinse, wie in Fig. 4 exemplarisch dargestellt, oder einem Linsensystem abgebildet werden. Statt eines Mikrolinsenarrays könnte auch ein Blenden-Array zur Abbildung verwendet werden oder eine Kombination von beidem. In beiden Fällen ließe sich die Blickrichtung jedes Pixels ermitteln, damit diese in eine Punktwolke überführt werden können, auf der sich die oben genannte Interpolation durchführen lässt.

Bei obigen Ausführungsbeispielen wird folglich inhärent eine Invertierung der Einzelbilder, eine Entzerrung derselben und eine Parallax-Korrektur in einem Schritt durchgeführt, was die Verarbeitung beschleunigt. Die Bildinformationen werden in einem Schritt zu einem Gesamtbild kombiniert und Interpolationszwischenschritte entfallen, was wiederum die Qualität des Gesamtbildes verbessert, da sich die Bildschärfe erhöht und Artefakte reduziert werden. Obige Ausführungsbeispiele sind für Sensoren mit Filtern geeignet. Dabei wäre es möglich, unter jeder Mikrolinse ein Farbfilterarray zu verwenden, oder unter jeder Mikrolinse ein Filter von genau einer Farbe zu platzieren. Letztgenannte Filter können RGB-Farbfilter sein und es ist auch möglich, zusätzliche Farben zu verwenden, z.B. RGB + Grau oder RGB + Zyan. Die Verwendung von Polarisationsfiltern oder Grau- bzw. Neutraldichtefiltern verschiedener Dichte ist ebenfalls möglich.

Somit ist es möglich, die Aufnahme von Farbbildern zu ermöglichen. Außerdem ist es möglich, Aufnahmen von Bildern mit Zusatzinformationen zu erzeugen, wie z.B. weitere spektrale Bilder im Bereich der Multispektralen Abbildung, Polarisationsinformationen, mehr Dynamikumfang usw.

Durch obige Ausführungsbeispiele wird es auch ermöglicht, dass nicht nur die Teilbilder zueinander global registriert werden, sondern jeder Bildpunkt des Bildes zu anderen. Eine Verzeichnung der Mikrobilder wird inhärent automatisch ausgeglichen. Verschiedene Mikrobilder können somit auch unterschiedlich verzeichnet sein, was die Anforderungen an das optische System deutlich reduziert. Die Optik 14 kann einfacher aufgebaut und kleiner/flacher sein, die Herstellungstoleranzen können größer sein und all das reduziert somit auch die Herstellungskosten der obigen Ausführungsbeispiele und verringert die Baugröße.

Obige Ausführungsbeispiele können bei Kamerasystemen in vielen Anwendungsgebieten eingesetzt werden, wie z.B. beim Mobiltelefonen, Videokonferenzsystemen, im Bereich medizinischer Anwendungen, in der Robotik, in Machine-Vision-Anwendungen, in Fahrzeugkameras und bei der Fernerkundung, speziell im Bereich der Multispektralabbildung. Aus Systemsicht sind obige Ausführungsbeispiele anwendbar bei Kameras mit Multiaperturabbildungssystemen und Kamera-Arrays, d.h. Systemen mit mehreren Kameras. In anderen Worten ausgedrückt, könnte jeder der obigen Kanäle natürlich auch einzeln aus einer Kamera gebildet sein, in welchem Fall oben genannter Bildsensor 12 in die einzelnen Chips der Kameras zerfiele, die jeweils einzeln für sich die Teilbereiche 24₁-24₃ bildeten, und die Optik 14 in einzelne Objektive der Kameras.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Bildaufnahmevorrichtung mit
einem Bildsensor mit einer Vielzahl von Bildpunkten, der ausgebildet ist, um in einer Aufnahme einen Abtastwert pro Bildpunkt zu erfassen;
einer Optik zur Erzeugung einer optischen Abbildung auf den Bildsensor, wobei die Optik eine Mehrkanaloptik zum individuellen Abbilden sich überlappender Raumwinkelbereiche auf separate Teilbereiche des Bildsensors umfasst, und wobei jedem Bildpunkt des Bildsensors ein Abbildungswert zugeordnet ist, wobei die Abbildungswerte Abbildungsrichtungen sind, die einem jeweiligen Bildpunkt durch eine Zuordnungsvorschrift zugeordnet sind und von der aus die Optik Objekte auf den jeweiligen Bildpunkt abbildet, oder wobei die Abbildungswerte laterale Abbildungspositionen in einer Schärfentiefenfläche sind, die dem jeweiligen Bildpunkt durch die Zuordnungsvorschrift zugeordnet sind und die die Optik auf den jeweiligen Bildpunkt abbildet;
einem Interpolator zum Interpolieren einer Verteilung der Abtastwerte der Bildpunkte gemäß ihren Abbildungswerten an Kreuzungspunkten eines regelmäßigen, sich über die gesamte Verteilung der Abtastwerte erstreckenden Gitters, um ein Array von Bildwerten zu erhalten;
einem Zuordner, der ausgebildet ist, um, für einen vorbestimmten Bildpunkt des Bildsensors, durch Berechnung anhand einer Lageinformation bezüglich des vorbestimmten Bildpunkts auf dem Bildsensor oder durch Nachschlagen anhand einer Referenz auf den vorbestimmten Bildpunkt den dem vorbestimmten Bildpunkt zugeordneten Abbildungswert über die Zuordnungsvorschrift zu ermitteln; und
einer Eingabeschnittstelle und/oder einem Entfernungsschätzer, die/der so ausgebildet ist, um für die Aufnahme zumindest zwischen einer Nahaufnahme und einer Fernaufnahme zu diskriminieren,
wobei der Zuordner ausgebildet ist, um in dem Fall einer Nahaufnahme die Ermittlung der Zuordnungsvorschrift unter Berücksichtigung von Parallax-Effekten so durchzuführen, dass die Abbildungswerte die lateralen Abbildungspositionen in der Schärfentiefenfläche sind, und in dem Fall einer Fernaufnahme die Ermittlung unter Vernachlässigung von Parallax-Effekten so durchzuführen, dass die Abbildungswerte die Abbildungsrichtungen sind.

2. Bildaufnahmevorrichtung gemäß Anspruch 1, bei der die Mehrkanaloptik so ausgebildet ist, dass die sich überlappenden Raumwinkelbereiche zusammen einen Gesamtraumwinkelbereich abdecken, der höchstens 120% größer ist als jeder der sich überlappenden Raumwinkelbereiche.

3. Bildaufnahmevorrichtung gemäß Anspruch 1, bei der die Mehrkanaloptik so ausgebildet ist, dass die sich überlappenden Raumwinkelbereiche zusammen einen Gesamtraumwinkelbereich abdecken, der mindestens viermal größer ist als jeder der sich überlappenden Raumwinkelbereiche.

4. Bildaufnahmevorrichtung gemäß einem der Ansprüche 1 bis 3, bei der die Optik so ausgebildet ist, dass die individuellen Abbildungen zueinander unterschiedlich, aber jede für sich lateral konstant spektral-, polarisations- oder neutraldichtegefiltert sind, wobei der Interpolator ausgebildet ist, um die Interpolation individuell für eine Verteilung der Abtastwerte solcher Bildpunkte durchzuführen, die zu Teilbereichen gehören, bei denen die jeweilige individuelle Abbildung auf dieselben gleich gefiltert ist.

5. Bildaufnahmevorrichtung gemäß Anspruch 4, bei der der Interpolator ausgebildet ist, um bei der individuellen Interpolation der Verteilung der Abtastwerte solcher Bildpunkte, die zu Teilbereichen gehören, bei denen die jeweilige individuelle Abbildung auf dieselben gleich gefiltert ist, auch die Verteilung von Abtastwerten von Bildpunkten zu berücksichtigen, die zu Teilbereichen gehören, bei denen die jeweilige individuelle Abbildung auf dieselben anders gefiltert ist.

6. Bildaufnahmevorrichtung gemäß einem der Ansprüche 1 bis 3, bei der die Bildpunkte des Bildsensors Bildpunktgruppen aufweisen, die zueinander unterschiedliche spektrale, Polarisations- und/oder Neutraldichteempfindlichkeit aufweisen, wobei jeder Teilbereich des Bildsensors zumindest Bildpunkte aus zwei verschiedenen der Bildpunktgruppen aufweist, und wobei der Interpolator ausgebildet ist, um die Interpolation individuell für die Bildpunktgruppen durchzuführen.

7. Bildaufnahmevorrichtung gemäß einem der Ansprüche 4 bis 6, bei der der Interpolator ausgebildet ist, um für die individuellen Filterungen das gleiche regelmäßige Gitter lagegleich zu verwenden.

8. Bildaufnahmevorrichtung gemäß einem der vorhergehenden Ansprüche, bei der die Bildaufnahmevorrichtung so ausgebildet ist, dass durch die Zuordnung der Abbildungswerte zu den Bildpunkten in dem Array von Bildwerten eine Verzeichnung der Optik ausgeglichen ist.

9. Bildaufnahmevorrichtung gemäß einem der vorhergehenden Ansprüche, bei der die Mehrkanaloptik eine Mehrzahl von Mikrolinsen aufweist, und die Zuordnung eines jeweiligen Abbildungswerts zu jedem Bildpunkt des Bildsensors abhängig von einer Richtung einer optischen Achse der Mikrolinsen der Mehrkanaloptik, Pixelkoordinaten der Bildpunkte unter den Mikrolinsen und einer Verzeichnung der Mikrolinsen ist.

10. Bildaufnahmevorrichtung gemäß einem der vorhergehenden Ansprüche, bei der der Interpolator ausgebildet ist, um zu jedem Kreuzungspunkt nächste Nachbarn unter der Verteilung von Abtastwerten zu finden und eine gewichtete Mittelung über die Abtastwerte mit einer Gewichtung, die dem Inversen des Abstands oder dem Inversen des Quadrats des Abstands zwischen dem jeweiligen Kreuzungspunkt und den den nächsten Nachbarn zugeordneten Abbildungswerten entspricht, durchzuführen.

11. Bildaufnahmevorrichtung gemäß einem der vorhergehenden Ansprüche, bei der die Mehrkanaloptik ein Array von Mikrolinsen aufweist, und ein Abstand der Optik von dem Bildsensor gleich oder größer als eine Brennweite der Mikrolinsen ist, und wobei ein mittlerer Abstand von Scheiteln der Mikrolinsen gegenüber einem Mittenabstand der Teilbereiche des Bildsensors vergrößert ist.

12. Verfahren zum Aufnehmen eines Bilds mittels eines Bildsensors mit einer Vielzahl von Bildpunkten, der ausgebildet ist, um in einer Aufnahme einen Abtastwert pro Bildpunkt zu erfassen, und einer Optik zur Erzeugung einer optischen Abbildung auf den Bildsensor, wobei die Optik eine Mehrkanaloptik zum individuellen Abbilden sich überlappender Raumwinkelbereiche auf separate Teilbereiche des Bildsensors umfasst, mit
Zuordnen, zu jedem Bildpunkt des Bildsensors, eines Abbildungswerts, wobei die Abbildungswerte Abbildungsrichtungen sind, die einem jeweiligen Bildpunkt durch eine Zuordnungsvorschrift zugeordnet sind und von der aus die Optik Objekte auf den jeweiligen Bildpunkt abbildet, oder wobei die Abbildungswerte laterale Abbildungspositionen in einer Schärfentiefenfläche sind, die dem jeweiligen Bildpunkt durch die Zuordnungsvorschrift zugeordnet sind und die die Optik auf den jeweiligen Bildpunkt abbildet; und
Interpolieren einer Verteilung der Abtastwerte der Bildpunkte gemäß ihren Abbildungswerten an Kreuzungspunkten eines regelmäßigen, sich über die gesamte Verteilung der Abtastwerte erstreckenden Gitters, um ein Array von Bildwerten zu erhalten,
Ermitteln, über die Zuordnungsvorschrift, für einen vorbestimmten Bildpunkt des Bildsensors, des dem vorbestimmten Bildpunkt zugeordneten Abbildungswerte durch Berechnung anhand einer Lageinformation bezüglich des vorbestimmten Bildpunkts auf dem Bildsensor oder durch Nachschlagen anhand einer Referenz auf den vorbestimmten Bildpunkt; und
Diskriminieren, mittels einer Eingabeschnittstelle und/oder einem Entfernungsschätzer, zumindest zwischen einer Nahaufnahme und einer Fernaufnahme für die Aufnahme,
in dem Fall einer Nahaufnahme die Ermittlung unter Berücksichtigung von Parallax-Effekten so durchgeführt wird, dass die Abbildungswerte laterale Abbildungspositionen in der Schärfentiefenfläche sind, und in dem Fall einer Fernaufnahme die Ermittlung unter Vernachlässigung von Parallax-Effekten so durchgeführt wird, dass die Abbildungswerte die Abbildungsrichtungen sind.

13. Computerprogramm mit einem Programmcode zur Durchführung des Verfahrens nach Anspruch 12, wenn das Programm auf einem Computer abläuft.

## Claims

1. A picture capturing apparatus comprising:
an image sensor comprising a multitude of pixels, said image sensor being configured to detect, in a photograph, a sample per pixel;
an optical element for producing optical imaging to the image sensor, the optical element comprising a multi-channel optical element for individually imaging overlapping solid-angle ranges to separate subareas of the image sensor, and wherein each pixel of the image sensor has an imaging value associated therewith, the imaging values being imaging directions which are associated to a respective pixel by an association rule and from which the optical element images objects to the respective pixel, or wherein the imaging values are lateral imaging positions within a focal-depth area that is associated to the respective pixel by the association rule and images the optical element to the respective pixel;
an interpolator for interpolating a distribution of the samples of the pixels in accordance with their imaging values at intersection points of a regular grid that extends across the entire distribution of the samples in order to obtain an array of picture values;
an associator configured to determine, for a predetermined pixel of the image sensor, the imaging value associated with the predetermined pixel by the association rule by means of calculation using positional information with regard to the predetermined pixel on the image sensor or by means of lookup using a reference to the predetermined pixel; and
an input interface and/or a distance estimator configured to distinguish, for the photograph, at least between a close-up shot and a long-distance shot,
the associator being configured to perform, in the event of a close-up shot, the determination of the association rule while taking into account parallax effects such that the imaging values are lateral imaging positions in the focal-depth area, and, in the event of a long-distance shot, to perform the determination while neglecting parallax effects, so that the imaging values are the imaging directions.

2. The picture capturing apparatus as claimed in claim 1, wherein the multi-channel optical element is configured such that the overlapping solid-angle ranges together cover an overall solid-angle range that is 120% larger, at the most, than any of the overlapping solid-angle ranges.

3. The picture capturing apparatus as claimed in claim 1, wherein the multi-channel optical element is configured such that the overlapping solid-angle ranges together cover an overall solid-angle range that is at least four times larger than any of the overlapping solid-angle ranges.

4. The picture capturing apparatus as claimed in any of claims 1 to 3, wherein the optical element is configured such that the individual images are mutually different, but taken individually are spectrally, polarization, or neutral-density filtered in a laterally constant manner, the interpolator being configured to individually perform interpolation for a distribution of the samples of such pixels that belong to subareas wherein the respective individual imaging to same is filtered identically.

5. The picture capturing apparatus as claimed in claim 4, wherein the interpolator is configured to also take into account, in the individual interpolation of the distribution of the samples of such pixels that belong to subareas wherein the respective individual imaging to same is filtered identically, the distribution of samples of pixels that belong to subareas wherein the respective individual imaging to same is filtered differently.

6. The picture capturing apparatus as claimed in any of claims 1 to 3, wherein the pixels of the image sensor comprise pixel groups comprising mutually different spectral, polarization and/or neutral-density sensitivities, each subarea of the image sensor comprising at least pixels from two different pixel groups, and wherein the interpolator is configured to perform the interpolation individually for the pixel groups.

7. The picture capturing apparatus as claimed in any of claims 4 to 6, wherein the interpolator is configured to use the same regular grid, in the same position, for the individual filtering operations.

8. The picture capturing apparatus as claimed in any of the previous claims, the picture capturing apparatus being configured such that a distortion of the optical element is balanced off by the association of the imaging values with the pixels in the array of picture values.

9. The picture capturing apparatus as claimed in any of the previous claims, wherein the multi-channel optical element comprises a plurality of microlenses, and the association of a respective imaging value with each pixel of the image sensor is dependent on a direction of an optical axis of the microlenses of the multi-channel optical element, pixel coordinates of the pixels among the microlenses, and a distortion of the microlenses.

10. The picture capturing apparatus as claimed in any of the previous claims, wherein the interpolator is configured to find, for each point of intersection, nearest neighbors among the distribution of samples, and to perform weighted averaging across the samples with a weighting which corresponds to the inverse of the distance or to the inverse of the square of the distance between the respective point of intersection and the imaging values associated with the nearest neighbors.

11. The picture capturing apparatus as claimed in any of the previous claims, wherein the multi-channel optical element comprises an array of microlenses, and a distance of the optical element from the image sensor is equal to or larger than a focal length of the microlenses, and wherein an average distance from vertices of the microlenses is enlarged in relation to a center-to-center distance of the subareas of the image sensor.

12. A method of capturing a picture by means of an image sensor comprising a multitude of pixels, said image sensor being configured to detect, in a photograph, a sample per pixel, and an optical element for creating optical imaging to the image sensor, the optical element comprising a multi-channel optical element for individually imaging overlapping solid-angle ranges to separate subareas of the image sensor, comprising
associating an imaging value with each pixel of the image sensor, the imaging values being imaging directions which are associated to a respective pixel by an association rule and from which the optical element images objects to the respective pixel, or wherein the imaging values are lateral imaging positions in a focal-depth area that is associated to the respective pixel by the association rule and images the optical element to the respective pixel by the optical element; and
interpolating a distribution of the samples of the pixels in accordance with their imaging values at intersection points of a regular grid extending across the entire distribution of the samples so as to obtain an array of picture values,
determining for a predetermined pixel of the image sensor, the imaging value associated with the predetermined pixel by the association rule by means of calculating using positional information with regard to the predetermined pixel on the image sensor or by means of looking up using a reference to the predetermined pixel; and
distinguishing at least between a close-up shot and a long-distance shot for the photograph by means of an input interface and/or a distance estimator,
wherein, in the event of a close-up shot, the determination is performed while taking into account parallax effects such that the imaging values are lateral imaging positions in the focal-depth area and, in the event of a long-distance shot, the determination is performed while neglecting parallax effects so that the imaging values are the imaging directions.

13. A computer program comprising a program code for performing the method as claimed in claim 12, when the program runs on a computer.

## Revendications

1. Appareil pour enregistrer des images, avec
un capteur d'image avec une pluralité de pixels qui est conçu pour détecter dans un enregistrement une valeur de balayage par pixel;
un système optique destiné à générer une reproduction optique sur le capteur d'image, où le système optique comporte un système optique multicanal destiné à reproduire individuellement des zones angulaires spatiales venant en recouvrement sur des zones partielles séparées du capteur d'image, et où une valeur de reproduction est associée à chaque pixel du capteur d'image, où les valeurs de reproduction sont des directions de reproduction qui sont associées à un pixel respectif par une règle d'association et à partir de laquelle le système optique reproduit des objets sur le pixel respectif, ou bien où les valeurs de reproduction sont des positions de reproduction latérales dans une zone de profondeur de champ qui sont associées à chaque pixel par la règle d'association et que le système optique reproduit sur le pixel respectif;
un interpolateur destiné à interpoler une distribution des valeurs de balayage des pixels selon leurs valeurs de reproduction aux points d'intersection d'une grille régulière s'étendant sur toute la distribution des valeurs de balayage, pour obtenir un réseau de valeurs d'image;
un associateur qui est conçu pour déterminer, pour un pixel prédéterminé du capteur d'image, par un calcul sur base d'une information de position par rapport au pixel prédéterminé sur le capteur d'image ou par consultation, à l'aide d'une référence sur le pixel prédéterminé, de la valeur de reproduction associée au pixel prédéterminé à l'aide de la règle d'association; et
une interface d'entrée et/ou un estimateur de distance qui est conçu(e) pour discriminer pour l'enregistrement d'image au moins entre un enregistrement en gros plan et un enregistrement à distance,
dans lequel l'associateur est conçu pour effectuer, dans le cas d'un enregistrement en gros plan, la détermination de la règle d'association, compte tenu des effets de parallaxe de sorte que les valeurs de reproduction soient les positions de reproduction latérales dans la profondeur de champs et pour effectuer, dans le cas d'un enregistrement à distance, la détermination en négligeant les effets de parallaxe de sorte que les valeurs de reproduction soient les directions de reproduction.

2. Appareil pour enregistrer des images selon la revendication 1, dans lequel le système optique multicanal est conçu de sorte que les zones angulaires spatiales venant en recouvrement couvrent ensemble une zone angulaire spatiale totale qui est tout au plus 120% plus grande que chacune des zones angulaires spatiales venant en recouvrement.

3. Appareil pour enregistrer des images selon la revendication 1, dans lequel le système optique multicanal est conçu de sorte que les zones angulaires spatiales venant en recouvrement couvrent ensemble une zone angulaire spatiale totale qui est au moins quatre fois plus grande que chacune des zones angulaires spatiales venant en recouvrement.

4. Appareil pour enregistrer des images selon l'une des revendications 1 à 3, dans lequel le système optique est conçu de sorte que les reproductions individuelles soient différentes entre elles, mais soient, chacune en soi, latéralement filtrées de manière spectrale, en polarisation ou en densité neutre de manière constante, dans lequel l'interpolateur est conçu pour effectuer l'interpolation individuellement pour une distribution des valeurs de balayage des pixels qui appartiennent à des zones partielles dans lesquelles la reproduction individuelle respective est filtrée de manière égale sur ces dernières.

5. Appareil pour enregistrer des images selon la revendication 4, dans lequel l'interpolateur est conçu pour tenir compte, lors de l'interpolation individuelle de la distribution des valeurs de balayage de tels pixels appartenant à des zones partielles dans lesquelles la reproduction individuelle respective sur ces dernières est filtrée de manière égale, également de la répartition de valeurs de balayage de pixels qui appartiennent à des zones partielles dans lesquelles la reproduction individuelle respective sur ces dernières est filtrée de manière différente.

6. Appareil pour enregistrer des images selon l'une des revendications 1 à 3, dans lequel les pixels du capteur d'image présentent des groupes de pixels qui présentent une sensibilité spectrale, de polarisation et/ou de densité neutre différente entre elles, dans lequel chaque zone partielle du capteur d'image présente au moins des pixels à partir de deux groupes de pixels différents, et dans lequel l'interpolateur est conçu pour effectuer l'interpolation individuellement pour les groupes de pixels.

7. Appareil pour enregistrer des images selon l'une des revendications 4 à 6, dans lequel l'interpolateur est conçu pour utiliser, pour les filtrations individuelles, la même grille régulière dans la même position.

8. Appareil pour enregistrer des images selon l'une des revendications précédentes, dans lequel le dispositif pour enregistrer des images est conçu de sorte que par l'association des valeurs de reproduction aux pixels dans la matrice de valeurs d'image soit compensée une distorsion du système optique.

9. Appareil pour enregistrer des images selon l'une des revendications précédentes, dans lequel le système optique multicanal présente une pluralité de microlentilles, et l'association d'une valeur de reproduction respective à chaque pixel du capteur d'image est fonction d'une direction d'un axe optique des microlentilles du système optique multicanal, des coordonnées des pixels sous les microlentilles et d'une distorsion des microlentilles.

10. Appareil pour enregistrer des images selon l'une des revendications précédentes, dans lequel l'interpolateur est conçu pour trouver à chaque intersection les voisins les plus proches dans la distribution de valeurs de balayage et pour réaliser un calcul de la moyenne pondéré sur les valeurs de balayage avec une pondération qui correspond à l'inverse de la distance ou à l'inverse du carré la distance entre le point d'intersection respectif et les valeurs de reproduction associées aux voisins les plus proches.

11. Appareil pour enregistrer des images selon l'une des revendications précédentes, dans lequel le système optique multicanal présente un réseau de microlentilles, et une distance du système optique par rapport au capteur d'image est égale ou supérieure à une distance focale des microlentilles, et dans lequel une distance moyenne des sommets des microlentilles par rapport à une distance centrale des zones partielles du capteur d'image est agrandie.

12. Procédé pour enregistrer une image au moyen d'un capteur d'image avec une pluralité de pixels qui est conçu pour détecter dans un enregistrement une valeur de balayage par pixel, et un système optique destiné à générer une reproduction optique sur le capteur d'image, dans lequel le système optique comporte un système optique multicanal pour la reproduction individuelle de zones angulaires spatiales qui viennent en recouvrement sur des zones partielles séparées du capteur d'image, avec le fait de associer à chaque pixel du capteur d'image une valeur de reproduction, dans lequel les valeurs de reproduction sont des directions de reproduction qui sont associées à un pixel respectif par une règle d'association et à partir de laquelle le système optique reproduit des objets sur le pixel respectif, ou bien où les valeurs de reproduction sont des positions de reproduction latérales dans une zone de profondeur de champ qui sont associées au pixel respectif par la règle d'association et que le système optique reproduit sur le pixel respectif; et
interpoler une distribution des valeurs de balayage des pixels selon leurs valeurs de reproduction à des points d'intersection d'une grille régulière s'étendant sur toute la distribution des valeurs de balayage, pour obtenir un réseau de valeurs d'image,
déterminer, par l'intermédiaire de la règle d'association, pour un pixel prédéterminé du capteur d'image, les valeurs de reproduction associées au pixel prédéterminé par calcul à l'aide d'une information d'emplacement par rapport au pixel prédéterminé sur le capteur d'image ou par consultation à l'aide d'une référence sur le pixel prédéterminé; et
discriminer, au moyen d'une interface d'entrée et/ou d'un estimateur de distance, au moins entre un enregistrement en gros plan et un enregistrement à distance pour l'enregistrement,
dans le cas d'un enregistrement en gros plan, la détermination est effectuée en tenant compte des effets de parallaxe de sorte que les valeurs de reproduction soient des positions de reproduction latérales dans la zone de profondeur de champ, et dans le cas d'un enregistrement à distance, la détermination est effectuée en négligeant les effets de parallaxe de sorte que les valeurs de reproduction soient les directions de reproduction.

13. Programme d'ordinateur avec un code de programme pour réaliser le procédé selon la revendication 12 lorsque le programme est exécuté sur un ordinateur.
